Europäisches Patentamt

European Patent Office

Office européen des brevets

(11) Publication number: 0 666 587 A1

# EUROPEAN PATENT APPLICATION
## published in accordance with Art. 158(3) EPC

(21) Application number: 94921810.1

(22) Date of filing: 25.07.94

(86) International application number: PCT/JP94/01221

(87) International publication number: WO 95/04370 (09.02.95 95/07)

(51) Int. Cl.6: H01L 21/027, G03F 7/16

(30) Priority: 30.07.93 JP 190296/93

(43) Date of publication of application: 09.08.95 Bulletin 95/32

(84) Designated Contracting States: CH DE FR GB LI NL

(71) Applicant: Nippon Paint Co., Ltd.
1-2 Oyodokita 2-chome
Kita-ku,
Osaka-shi,
Osaka 531 (JP)

(72) Inventor: MATSUO, Seiichi
2-5-3, Awaji
Higashiyodogawa-ku
Osaka-shi
Osaka 533 (JP)
Inventor: IKEDA, Takeshi
36-11-502, Toyozato-cho
Neyagawa-shi
Osaka 572 (JP)
Inventor: SHIMIZU, Makoto
6-8-26, Kitatanabe
Higashisumiyoshi-ku
Osaka-shi
Osaka 546 (JP)
Inventor: KAWAMURA, Kazuyuki
10-10-522, Akishino Satsuki-cho
Nara-shi
Nara 631 (JP)

(74) Representative: Perry, Robert Edward
GILL JENNINGS & EVERY
Broadgate House
7 Eldon Street
London EC2M 7LH (GB)

(54) METHOD FOR ELECTRODEPOSITION OF PHOTOSENSITIVE RESIST.

(57) A method is provided for electrodeposition of a photosensitive resist film for precise lithography in a microminiature circuit process. A constant voltage of 150 to 350 V is applied, and if the logarithm of the current deviates from a given value, the energization is stopped, thus forming a film having a good adhesion and resistance to etching solution.

Fig. 1

LOGARITHMIC VALUE OF ELECTRODEPOSITION CURRENT

log i

COVERING PROCESS

SUPERIMPOSING PROCESS

COMPLETION OF COATING

POWER APPLICATION PERIOD (SECOND)

## TECHNICAL FIELD

The present invention relates to a method for fabricating a precision micro-processed component by forming a photosensitive resist film by an electrodeposition method, then subjecting the photosensitive resist film to exposure, development, etching and the like.

## BACKGROUND ART

Hitherto, the method of photoetching has been known as a method for fabricating precision micro-processed components using a photosensitive resist, which is described in detail in "Illustrated Photofabrication" (published by "Sogo Denshi Shuppan", 1986). In particular, for forming a wiring pattern on a printed wiring board, it is customary to form a photosensitive resist film on a metallic material, such as a copper-clad laminate, place a pattern mask thereon, and expose the masked photosensitive resist film to light. Then, any unexposed portion is washed away with a developing solution, and etching with a metal etching liquid is done for pattern formation with respect to exposed metal portions. Various methods are known for formation of such a resist film, including (i) a method in which films having photosensitive resist layers are superimposed, (ii) a method in which a photosensitive resist in the form of a solution is applied by dip coating, roll coating, or curtain coating or otherwise, and (iii) a method in which a photosensitive resist layer is formed by electrodeposition.

Electrodeposition methods have been receiving good attention for various reasons: (i) that the methods provide good close contact with the material; (ii) that the methods are well adaptable to cope with surface irregularities; and (iii) that the methods enable hole interior treatment for a substrate having through-holes formed therein. Indeed, good progress has recently been made toward practical application of such methods.

For electrodeposition of printed wiring boards, conventional practice has been such that a substrate is dipped in an electrodeposition liquid by being suspended therein, with power applied for 1 to 3 minutes according to a predetermined energization program and under conditions adapted for provision of a desired film thickness.

Recently, with increased demand for high density and high precision packaging with respect to printed wiring boards, greater needs have arisen for production of microcircuit patterns at a good yield. With conventional electrodeposition methods during the process of microcircuit forming occurrence of wire breaks due to improper resist adhesion and wire thinning due to passage of etch liquid through the resist film. This has made it impractical to achieve any microcircuit formation at a good yield.

## DISCLOSURE OF INVENTION

It is an object of the invention to provide a method for fabricating a photosensitive resist film in a precision micro-processed component, capable of forming a resist film having high capability to form microcircuitry, when electrodeposition of a photosensitive resist is carried out.

The present inventors eagerly made several attempts in order to solve the foregoing problems. As a result, it was discovered that an electrodeposited film having good adhesion properties and etchant resistance could be formed by carrying out power application in a constant voltage range of 150 to 350 V, and stopping the power application at a point of time at which the decreasing amount of logarithmic values of the passing current goes out of a specific constant value.

According to one aspect of the present invention, during the electrodeposition, the time point at which the surface of the substrate is covered all over is read from a current variation, and power application is then stopped, whereby any excessive energization detrimental to the photosensitive resist can be avoided. Thus it is possible to obtain a resist film having good physical properties suitable for microcircuitry formation.

## BRIEF DESCRIPTION OF DRAWINGS

These and other objects, and advantages of the invention will become more apparent from the following description relating to the preferred embodiments when taken in conjunction with the accompanying drawings, in which:

Fig. 1 is a graph showing the relationship between logarithmic values of an electrodeposition current and power application period;

Fig. 2 is a graph showing the relationship between film weight and electrocoating liquid temperature; and

Fig. 3 is a graph showing the relationship between electrodeposited area and power application period.

## BEST MODE FOR CARRYING OUT THE INVENTION

Generally it is known that the process of electrodeposited film forming is divided into the following three stages:

(i) an induction stage in which $H^+$ is accumulated on the surface of the substrate by water electrolysis;

(ii) a covering stage in which an electrodeposited resist once covers the surface all over; and

(iii) a superimposing stage in which electrodeposition progresses via pores of coat films and in which the coat films are superimposed.

The present inventors have found that when the electrodeposition of a photosensitive resist is carried out, the superimposing stage is extremely harmful from the standpoint of development, and that the longer the electrodeposition time in the superimposing stage, the more likely that occurrences of wire breaks due to resist peel resulting from improper resist adhesion, and wire thinning due to etchant degradation, will appear.

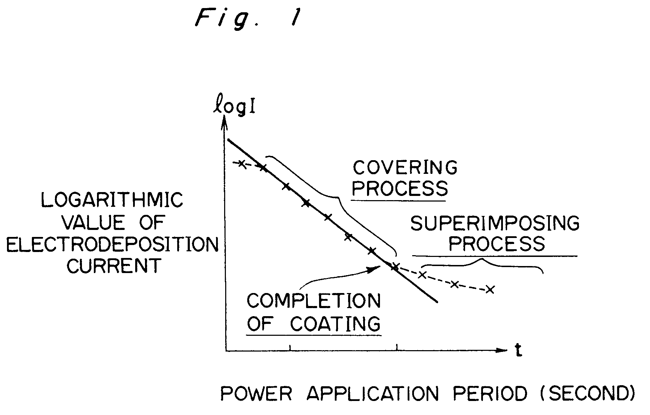

The ending time point of the covering stage can be read from a time-varying current curve during electrodeposition at constant voltage. Specifically, by tracking changes in electrodeposition current logarithmic values with respect to time, the time point at which the rate of decreasing amount varies may be judged as an ending point, because such decreasing amount is occurring at a constant rate during the covering stage. For example, a graph is prepared which shows the relationship between electrodeposition current logarithmic value and power application period as in Fig. 1. From this graph it is possible to read the point at which a straight line representing the covering stage changes into the superimposing stage, as the electrodeposition ending time point.

Thus, in a method for fabricating a precision micro-processed component in which the photosensitive resist film is formed by electrodeposition on a conductive material, the present invention is so constructed in that application of power is stopped so as to avoid excessive energization when an electrodeposited film has covered the surface of a substrate all over.

According to this construction, it is possible to carry out electrodeposition through power application in a constant voltage range of 150 to 350 V so that electrodeposition takes place in a range of 80 to 200 % of a power application period of the time point at which the rate of decreasing amount with respect to logarithmic values of the electrodeposition current changes from the specific constant value.

Furthermore, according to this construction, it is possible to arrange the power application period such that it is not more than 20 seconds and the thickness of the resist film is not more than 15 $\mu$.

In the present invention, a proper power application period is preferably within a range of 80 to 200 % of the time period of up to the ending time. If the energization time is too short, full surface coverage cannot be effected. If such time is too long, the adhesion property and etchant resistance will be lowered.

For power application, electrodeposition is carried out according to a program such that energization is stopped at a time preset by the method, but preferably an automatically controlled program be employed wherein electrodeposition current data during power application is followed and computed so that the ending point is automatically determined to enable power stoppage.

Generally, a time-varying electrodeposition current curve is susceptible to variable factors, such as electrodeposition liquid temperature, non-volatile content, neutralizer concentration, solvent quantity, size of substrate, inter-electrode distance, and electrodeposition liquid flow rate. Therefore, the ending time is likely to fluctuate. When the foregoing automatic control is employed, it is possible to inhibit changes in the performance of the electrodeposited resist due to such variations, at the electrodeposition line.

Generally, electrodepositable anion-type photosensitive resists include a negative type whereby a non-exposed portion is washed away during development, and a positive type whereby an exposed portion is washed away. Either of these types of resists can be used for the purpose of the invention. Various compositions for photosensitive resist liquids have hitherto been proposed in a number of publications, including Japanese Laid-Open Patent Publications Nos. 3-177586 and 2-42446. Typically, such compositions are aqueous dispersions composed principally of photopolymerizable polymers, oligomers, and monomers which have radical functional groups, such as vinyl groups, and of photopolymerizable initiates. In the present invention, an electroconductive material may be an electrodepositable conductor. Examples of such material include metals, such as copper, aluminum, and iron, and alloys thereof, oxides thereof, organic conductive materials, and conductivity-treated insulator materials.

For electrodeposition voltages applicable in the invention, 100 V - 400 V are preferred. More preferably, they are 150 - 350 V. A voltage lower than this range is likely to cause wire breaks due to improper resist adhesion. Voltages higher than this range are likely to cause breakage of resist films formed which may lead to pinhole occurrences.

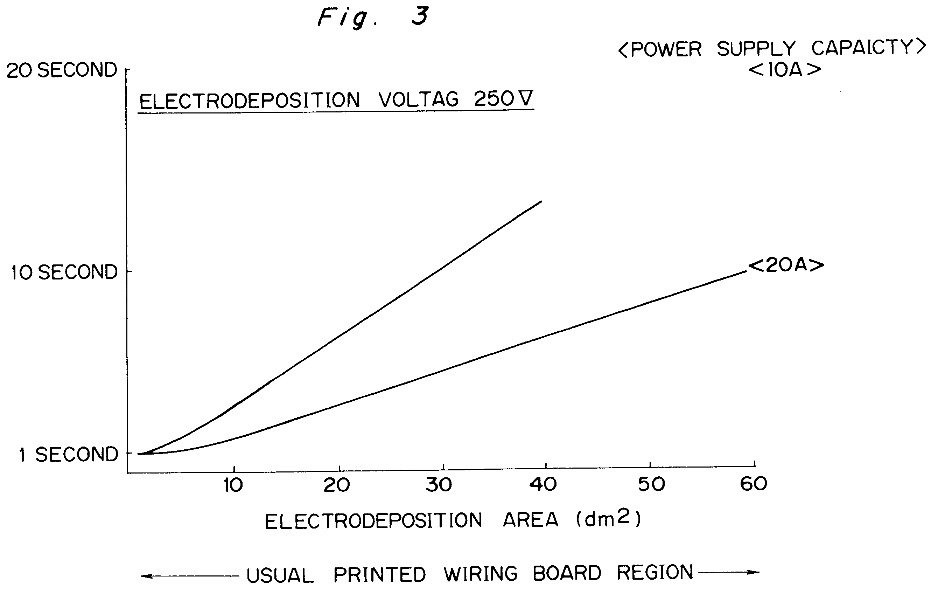

With the method of power application of the invention in use, there is no possibility of voltage being applied after the electrodeposited liquid covers the substrate all over, and fracture is unlikely to occur with the electrodeposited coat. Therefore, electrodeposition is possible under higher voltage than in the conventional one and the fact that the superimposing stage can be omitted, permits the process of electrodeposition to be completed in a considerably short time. For example, the electrodeposition time according to the invention may be only 1 to 20 seconds in a voltage range of 150 to 350 V as compared with the conventional constant voltage and constant current methods in which 1 to 3 minutes is required for electrodeposition where the voltage applied is not more than 150 V. The time required for power application depends upon various factors, such as voltage, substrate area, and capacity of power supply. See Fig. 3.

Such high-voltage short time electrodeposition of the invention is advantageous in that production time is shortened, with considerable improvement in productivity. In addition, the rate of turnover of resist liquid in the electrodeposition bath can be accelerated; this provides for prevention of liquid deterioration with time. More surprisingly, it has been found that such high-voltage short time electrodeposition permits formation of aesthetically much finer and more lustrous uniform coating than that obtainable according to the conventional method. Conceivably, the reason for this may be that in the conventional method, during the time-consuming superimposing stage, bubbles and turbulence present in the flow of liquid and roughness of substrate surface condition result in reduced smoothness of the electrocoated film. The fact that uniform resist film formation is possible requires surface roughness of micron scale. The present invention can have an effect capable of improving the yield production of the required fundamental performance in the usage of the photosensitive resist film.

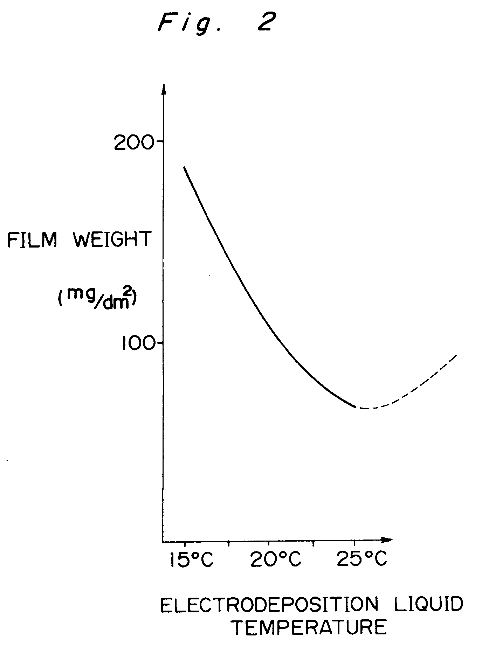

The electrodeposition method of the invention includes no superimposing stage which is usual with the conventional method. A consistent film having same thickness as according to the conventional method cannot be obtained under the same conditions as in the conventional method. As Fig. 2 shows, however, film thickness is dependent upon the electrodeposition temperature. Therefore, by controlling the electrodeposition liquid temperature it is possible to easily obtain any desired film thickness. Of course, it is possible to design a resist liquid composition so as to suit the method of the invention, thereby controlling film thickness.

For the resist film thickness, 1 to 15 $\mu$ is preferred in consideration of the required level for microcircuiting and ease of handling.

Using an electrodeposition liquid for a positive type anionic electrodeposited resist (Photo ED P-2000), made by Nippon Paint Co., Ltd., with a 0.6 mm thick double-side copper-clad laminate (40 x 180 mm) as an anode, electrodeposition was carried out at a liquid temperature of 25°C, with constant voltage DC power supply of 50, 150, 250, 350, and 500 V. Power application time was set so as to be stopped at a covering stage ending time point determined according to the Fig. 1 method on the basis of a time-varying electrodeposition current curve as previously determined by preliminary electrodeposition experiments. After electrodeposition, the coated panel was washed with water, water present on both sides thereof was removed by air blowing, and then same was heated and dried for 7 minutes in an oven at 100°C. Then a mask film having a microfine pattern of line/space = 30/30 $\mu$ was brought into contact with the coated panel at room temperature of 25°C by a vacuum device, and both sides were irradiated with ultraviolet light of 450 mJ/cm$^2$ using an ultrahigh pressure mercury light. The exposed panel was developed with 1 wt% sodium carbonate at 35°C. The developed panel was copper-etched with an etching solution composed principally of ferric chloride to give a printed wiring board having a circuit pattern formed thereon. Conditions of the formed circuit pattern and conditions of electrodeposition, and electrocoated film weights are shown in Table 1.

Table 1:

| | Example | | | | | Comparative Example | | |
|---|---|---|---|---|---|---|---|---|
| Electrodeposition voltage | 50V | 150V | 250V | 350V | 500V | 50V | 150V | Constant current |
| Power application period | 2.3 sec | 1.5 sec | 1 sec | 0.8 sec | 0.5 sec | 60 sec | 60 sec | 50mA/dm² ×60 sec |
| Film outer appearance | Gloss lowered | Good | Good | Good | with pinhole | Gloss lowered | | No gloss |
| Circuit formation | Wire break | Good | Good | Good | Wire break | Wire break | | Wire thinning |
| Film weight (mg/dm²) | 40 | 50 | 50 | 70 | 80 | 60 | 65 | 65 |

Conditions of ending point and adjacent points in 250 V electrodeposition are shown in Table 2.

5

Table 2:

| Electrodeposition voltage | 250V | | | | | |
|---|---|---|---|---|---|---|
| Power application period (%) * | 0.6 sec (60%) | 0.8 sec (80%) | 1 sec (100%) | 2 sec (200%) | 4 sec (400%) | 10 sec (1000%) |
| Coat condition | with uncoated portion | Coated all over | | | | |
| Film appearance | Good | Good | Good | Good | Gloss lowered | Gloss lowered |
| Circuit formation | – | Good | Good | Good | Wire thinning | Wire break |
| Film weight (mg/dm²) | 30 | 50 | 60 | 65 | 70 | 80 |

* % of power application period of up to ending point

(Comparative Examples)

Same conditions as in the foregoing Examples were used, except that electrodeposition was carried out with power application for one minute at constant voltage DC power supply of 50 V and 150 V, or constant current DC power supply of 50 mA/dm², and that development was made at 30 °C. Results with respect to printed wiring boards are also shown in Table 1.

Application of the electrodeposition method of the invention can provide for the formation of a microfine circuitry which was conventionally rendered impossible because of wire breaking and wire thinning.

Although the present invention has been fully described in connection with the preferred embodiments thereof with reference to the accompanying drawings, it is to be noted that various changes and modifications are apparent to those skilled in the art. Such changes and modifications are to be understood as included within the scope of the present invention as defined by the appended claims unless they depart therefrom.

## Claims

1. A method of making a photosensitive resist film in fabrication of a precision micro-processed component in which the photosensitive resist film is formed by electrodeposition on a conductive material, which is characterized by stopping application of power so as to avoid excessive energization when an electrodeposited film has covered a surface of a substrate all over.

2. The method of making a photosensitive resist film according to claim 1, wherein electrodeposition is carried out through power application in a constant voltage range of 150 to 350 V so that electrodeposition takes place in a range of 80 to 200 % of a power application period of the time point at which a rate of a decreasing amount with respect to logarithmic value of electrodeposition current goes out of a specific constant value.

3. The method of making a photosensitive resist film according to claim 2, wherein the power application period is not more than 20 seconds and a thickness of the resist film is not more than 15 $\mu$.

## *Fig. 1*

LOGARITHMIC
VALUE OF
ELECTRODEPOSITION
CURRENT

$\log I$

COVERING
PROCESS

SUPERIMPOSING
PROCESS

COMPLETION
OF COATING

t

POWER APPLICATION PERIOD (SECOND)

# Fig. 2

FILM WEIGHT

$(mg/dm^2)$

200

100

15°C    20°C    25°C

ELECTRODEPOSITION LIQUID
TEMPERATURE

# Fig. 3

<POWER SUPPLY CAPAICTY>
<IOA>

ELECTRODEPOSITION VOLTAG 250 V

20 SECOND

10 SECOND

1 SECOND

<20A>

10  20  30  40  50  60

ELECTRODEPOSITION AREA (dm2)

← —————— USUAL PRINTED WIRING BOARD REGION ————→

# INTERNATIONAL SEARCH REPORT

International application No.

PCT/JP94/01221

949218 10.1

## A. CLASSIFICATION OF SUBJECT MATTER

Int. Cl5 H01L21/027, G03F7/16

According to International Patent Classification (IPC) or to both national classification and IPC

## B. FIELDS SEARCHED

Minimum documentation searched (classification system followed by classification symbols)

Int. Cl5 H01L21/027, G03F7/16

Documentation searched other than minimum documentation to the extent that such documents are included in the fields searched

Jitsuyo Shinan Koho         1950 - 1994
Kokai Jitsuyo Shinan Koho   1971 - 1994

Electronic data base consulted during the international search (name of data base and, where practicable, search terms used)

## C. DOCUMENTS CONSIDERED TO BE RELEVANT

| Category* | Citation of document, with indication, where appropriate, of the relevant passages | Relevant to claim No. |
|---|---|---|
| Y | JP, A, 63-56918 (Mitsubishi Electric Corp.), March 11, 1988 (11. 03. 88), (Family: none) | 1-3 |

☐ Further documents are listed in the continuation of Box C.      ☐ See patent family annex.

*    Special categories of cited documents:
"A"  document defining the general state of the art which is not considered to be of particular relevance
"E"  earlier document but published on or after the international filing date
"L"  document which may throw doubts on priority claim(s) or which is cited to establish the publication date of another citation or other special reason (as specified)
"O"  document referring to an oral disclosure, use, exhibition or other means
"P"  document published prior to the international filing date but later than the priority date claimed

"T"  later document published after the international filing date or priority date and not in conflict with the application but cited to understand the principle or theory underlying the invention
"X"  document of particular relevance; the claimed invention cannot be considered novel or cannot be considered to involve an inventive step when the document is taken alone
"Y"  document of particular relevance; the claimed invention cannot be considered to involve an inventive step when the document is combined with one or more other such documents, such combination being obvious to a person skilled in the art
"&"  document member of the same patent family

| Date of the actual completion of the international search | Date of mailing of the international search report |
|---|---|
| August 5, 1994 (05. 08. 94) | August 23, 1994 (23. 08. 94) |

| Name and mailing address of the ISA/ | Authorized officer |
|---|---|
| Japanese Patent Office | |
| Facsimile No. | Telephone No. |

Form PCT/ISA/210 (second sheet) (July 1992)